# EUROPÄISCHE PATENTANMELDUNG

(11) **EP 4 297 080 A1**
(43) Veröffentlichungstag der Anmeldung: **27.12.2023**
(21) Anmeldenummer: 22179922.4
(22) Anmeldetag: 20.06.2022
(51) Int. Cl.: H01L 23/40, H01L 23/433, H01L 23/492, H01L 23/373, H01L 23/495

(54) **SCHALTUNGSANORDNUNG MIT EINEM SCHALTUNGSTRÄGER UND EINEM HALBLEITERBAUELEMENT**

(71) Anmelder: Siemens Aktiengesellschaft, 80333 München (DE)
(72) Erfinder: Hensler, Alexander, 91466 Gerhardshofen (DE); Strogies, Jörg, 14163 Berlin (DE); Heimann, Matthias, 14469 Potsdam (DE); Müller, Bernd, 16259 Falkenberg (DE); Oschmann, Philipp, 91058 Erlangen (DE); Pfefferlein, Stefan, 90562 Heroldsberg (DE)
(74) Vertreter: Siemens Patent Attorneys

(57) **Zusammenfassung**

Die Erfindung betrifft eine Schaltungsanordnung (1) mit einem Schaltungsträger (3), einem Halbleiterbauelement (5), einem Leadframe (7), einem elektrisch isolierenden Isolationselement (9), einem Kühlkörper (11) und einer Andrückeinrichtung (13). Das Halbleiterbauelement (5) ist zwischen dem Schaltungsträger (3) und dem Leadframe (7) angeordnet. Der Kühlkörper (11) ist auf einer von dem Halbleiterbauelement (5) abgewandten Seite des Leadframes (7) angeordnet. Das Isolationselement (9) ist zwischen dem Leadframe (7) und dem Kühlkörper (11) angeordnet. Die Andrückeinrichtung (13) ist eingerichtet, den Schaltungsträger (3), das Halbleiterbauelement (5), das Leadframe (7), das Isolationselement (9) und den Kühlkörper (11) aneinander zu drücken.

## Beschreibung

Die Erfindung betrifft eine Schaltungsanordnung mit einem Schaltungsträger und einem Halbleiterbauelement.

Im Bereich der Leistungselektronik liegen Halbleiterbauelemente, beispielsweise Schaltelemente, in der Regel in Form von Leistungsmodulen, auch als Powermodule bezeichnet, oder in Form von diskreten Packages vor. Die Halbleiterbauelemente werden dabei meist mittels spezifischer Drahtbondtechnologien kontaktiert und die Leistungsmodule werden zum Beispiel mittels Löt-, Feder- oder Pressverbindungen an einem Schaltungsträger befestigt. Durch die Verwendung von Bonddrähten wird die maximal zulässige Stromdichte durch die Halbleiterbauelemente limitiert. Außerdem kommt es zu parasitären Induktivitäten, welche eine erzielbare Schaltgeschwindigkeit der Schaltelemente begrenzt.

WO 2020/249479 A1 offenbart einen elektronischen Schaltkreis, der unter anderem einen ersten Schaltungsträger, einen zweiten Schaltungsträger und ein leistungselektronisches Halbleiterbauelement aufweist. Das Halbleiterbauelement weist eine Oberseite auf, die an einer Unterseite des ersten Schaltungsträgers anliegt, sowie eine Unterseite, die an einer Oberseite des zweiten Schaltungsträgers anliegt. Der erste Schaltungsträger weist eine Durchkontaktierung auf, welche die Oberseite des ersten Halbleiterbauelements elektrisch mit einer Leiterbahn des ersten Schaltungsträgers verbindet. Der zweite Schaltungsträger weist beispielsweise eine seine Oberseite bildende elektrisch leitfähige Schicht und eine, auf einer dem ersten Schaltungsträger abgewandten Seite der elektrisch leitfähigen Schicht angeordnete, elektrisch isolierende Schicht auf. Bei einer derartigen Anordnung von Schaltungsträgern und Halbleiterbauelement besteht das Problem, dass die beiden Schaltungsträger sehr unterschiedliche Ausdehnungskoeffizienten aufweisen können. Dies führt nach einer stoffschlüssigen Verbindung, beispielsweise durch Löten oder Sintern, dieser zwei Schaltungsträger nach deren Abkühlung zu einer starken Verwölbung des Verbundes. Infolgedessen kann der zweite Schaltungsträger nicht vollflächig an einen Kühlkörper angedrückt werden, wodurch die Wärmeableitung von dem Schaltkreis beeinträchtigt wird. Die unterschiedlichen Ausdehnungskoeffizienten der Schaltungsträger können außerdem zu Rissbildungen in den Schichten des zweiten Schaltungsträgers führen, die zu Zuverlässigkeitsproblemen bis hin zum Ausfall des gesamten Schaltkreises führen können.

Der Erfindung liegt die Aufgabe zugrunde, eine verbesserte Schaltungsanordnung anzugeben, die diese Probleme überwindet.

Die Aufgabe wird erfindungsgemäß durch eine Schaltungsanordnung mit den Merkmalen des Anspruchs 1 gelöst.

Vorteilhafte Ausgestaltungen der Erfindung sind Gegenstand der Unteransprüche.

Eine erfindungsgemäße Schaltungsanordnung umfasst
- einen Schaltungsträger,
- ein Leadframe,
- ein zwischen dem Schaltungsträger und dem Leadframe angeordnetes Halbleiterbauelement,
- einen auf einer von dem Halbleiterbauelement abgewandten Seite des Leadframes angeordneten Kühlkörper,
- ein zwischen dem Leadframe und dem Kühlkörper angeordnetes elektrisch isolierendes Isolationselement und
- eine Andrückeinrichtung, die eingerichtet ist, den Schaltungsträger, das Halbleiterbauelement, das Leadframe, das Isolationselement und den Kühlkörper aneinander zu drücken.

Gegenüber beispielsweise der aus WO 2020/249479 A1 bekannten Schaltungsanordnung weist die erfindungsgemäße Schaltungsanordnung statt zweier Schaltungsträger, zwischen denen das Halbleiterbauelement angeordnet ist, einen Schaltungsträger und ein Leadframe auf, zwischen denen das Halbleiterbauelement angeordnet ist. Außerdem weist die Schaltungsanordnung ein Isolationselement auf, das zwischen dem Leadframe und dem Kühlkörper angeordnet ist. Das Leadframe und das Isolationselement übernehmen dabei die Funktionen des zweiten Schaltungsträgers der aus WO 2020/249479 A1 bekannten Schaltungsanordnung, nämlich die elektrische Kontaktierung des Halbleiterbauelements auf der dem Leadframe zugewandten Seite des Halbleiterbauelements und die Wärmeleitung von dem Halbleiterbauelement zu dem Kühlkörper.

Durch die Entkopplung des Leadframes von dem Isolationselement kann das Problem des Verwölbens der Schaltungsanordnung gelöst werden, nämlich dadurch, dass das Leadframe aus einem Material gefertigt wird, das einen dem Schaltungsträger ähnlichen Ausdehnungskoeffizienten aufweist, und das Isolationselement und das Leadframe nicht stoffschlüssig verbunden sind. Dadurch wird auch die Gefahr einer Rissbildung in dem Leadframe gegenüber einer Rissbildung in einer elektrisch leitenden Schicht eines zweiten Schaltungsträgers deutlich reduziert und eine potentiell höhere Lebensdauer der Schaltungsanordnung ermöglicht.

Die Andrückeinrichtung ermöglicht temperaturunabhängig große Kontaktflächen und damit einen guten Wärmeübergang zwischen dem Kühlkörper, dem Isolationselement und dem Leadframe und damit eine verbesserte Entwärmung des Halbleiterbauelements.

Das Ersetzen des zweiten Schaltungsträgers der WO 2020/249479 A1 durch eine Kombination des Leadframes und des Isolationselements senkt außerdem vorteilhaft die Kosten der Schaltungsanordnung, da kein teurer zweiter Schaltungsträger benötigt wird. Zudem kann eine Dicke des Leadframes deutlich höher gestaltet werden als die Dicke einer elektrisch leitenden Schicht des zweiten Schaltungsträgers der WO 2020/249479 A1, was zu einer verbesserten Wärmespreizung an dem Halbleiterbauelement führt.

Die Formulierung, dass die Schaltungsanordnung ein Halbleiterbauelement aufweist, schließt nicht aus, dass die Schaltungsanordnung mehrere Halbleiterbauelemente aufweist, und ist mithin derart zu verstehen, dass die Schaltungsanordnung wenigstens ein Halbleiterbauelement aufweist. Entsprechendes trifft für die Formulierungen zu, dass die Schaltungsanordnung einen Schaltungsträger beziehungsweise ein Leadframe aufweist. Beispielsweise kann die Schaltungsanordnung mehrere Halbleiterbauelemente, die jeweils zwischen einem Schaltungsträger und einem Leadframe angeordnet sind, und ein zwischen dem Kühlkörper und jedem Leadframe angeordnetes Isolationselement aufweisen. Dabei kann die Schaltungsanordnung einen Schaltungsträger, an dem alle Halbleiterbauelemente angeordnet sind, oder mehrere Schaltungsträger, an denen jeweils wenigstens ein Halbleiterbauelement angeordnet ist, aufweisen. Entsprechend kann die Schaltungsanordnung ein Leadframe für alle Halbleiterbauelemente oder mehrere Leadframes für jeweils wenigstens ein Halbleiterbauelement aufweisen. Wenn die Schaltungsanordnung mehrere Halbleiterbauelemente aufweist, ist beispielsweise wenigstens ein Paar zweier dieser Halbleiterbauelemente elektrisch zu einer Halbbrücke verschaltet. Die Verschaltung zweier Halbleiterbauelemente kann beispielsweise über einen Schaltungsträger, an dem beide Halbleiterbauelemente angeordnet sind, oder über einen weiteren Schaltungsträger, der mit zwei Schaltungsträgern, an denen jeweils eines der beiden Halbleiterbauelemente angeordnet ist, elektrisch verbunden ist, erfolgen.

Bei einer Ausgestaltung der Erfindung ist das Isolationselement eine Keramikplatte. Beispielsweise ist die Keramikplatte aus Aluminiumoxid, Aluminiumnitrid oder Siliziumnitrid gefertigt. Ein derartiges Isolationselement weist eine hohe Wärmeleitfähigkeit und mechanische Stabilität gegenüber der Andrückkraft der Andrückeinrichtung auf.

Bei einer anderen Ausgestaltung der Erfindung ist das Isolationselement eine Isolationsfolie. Beispielsweise ist die Isolationsfolie aus einem silikonbasierten Material gefertigt. Eine Isolationsfolie ist durch ihre Flexibilität vorteilhaft weitgehend unempfindlich gegenüber Temperaturänderungen und der Andrückkraft der Andrückeinrichtung und daher ebenfalls als Isolationselement geeignet.

Bei einer weiteren Ausgestaltung der Erfindung weist der Kühlkörper eine Aussparung auf, in die das Isolationselement eingelegt ist. Die Aussparung legt vorteilhaft die Position des Isolationselements fest, insbesondere wenn das Isolationselement nicht stoffschlüssig mit dem Kühlkörper verbunden ist.

Bei einer weiteren Ausgestaltung der Erfindung ist das Isolationselement weder mit dem Kühlkörper noch mit dem Leadframe stoffschlüssig verbunden. Wie oben bereits ausgeführt wurde, ist eine stoffschlüssige Verbindung des Isolationselements mit dem Kühlkörper oder dem Leadframe nicht erwünscht, damit das Isolationselement flexibel und unabhängig von Temperaturänderungen anderer Komponenten der Schaltungsanordnung durch die Andrückeinrichtung an das Leadframe und den Kühlkörper gedrückt werden kann.

Bei einer weiteren Ausgestaltung der Erfindung ist zwischen dem Isolationselement und dem Kühlkörper und/oder zwischen dem Isolationselement und dem Leadframe ein Wärmeleitmedium angeordnet. Beispielsweise ist das Wärmeleitmedium ein Wärmeleitöl. Das Wärmeleitmedium erhöht vorteilhaft die Wärmeübertragung zwischen dem Isolationselement und dem Kühlkörper und/oder zwischen dem Isolationselement und dem Leadframe und verbessert damit insbesondere die Entwärmung des Halbleiterbauelements.

Bei einer weiteren Ausgestaltung der Erfindung weisen das Leadframe und der Schaltungsträger ähnliche Wärmeausdehnungskoeffizienten auf. Dadurch wird einer Verwölbung des Leadframes und des Schaltungsträgers durch große Unterschiede der Wärmeausdehnungskoeffizienten des Leadframes und des Schaltungsträgers entgegengewirkt.

Bei einer weiteren Ausgestaltung der Erfindung ist das Leadframe aus Kupfer gefertigt. Diese Ausgestaltung der Erfindung ist insbesondere vorteilhaft, wenn der erste Schaltungsträger eine Leiterplatte ist, da übliche Leiterplatten einen ähnlichen Wärmeausdehnungskoeffizienten wie Kupfer aufweisen.

Bei einer weiteren Ausgestaltung der Erfindung weist die Andrückeinrichtung wenigstens eine Schraubverbindung auf, die den Kühlkörper mit dem Schaltungsträger oder mit einer Andrückplatte, die auf einer von dem Kühlkörper abgewandten Seite des Schaltungsträgers angeordnet ist, verbindet. Eine derartige Schraubverbindung ist eine einfach, kostengünstig und mit flexibler Andrückkraft realisierbare Ausführung der Andrückeinrichtung.

Bei einer weiteren Ausgestaltung der Erfindung ist der Schaltungsträger eine Leiterplatte, insbesondere eine mehrlagige Leiterplatte. Die Ausführung des Schaltungsträgers als eine Leiterplatte hat insbesondere den Vorteil, dass das Halbleiterbauelement mit in oder auf der Leiterplatte verlaufenden Leiterbahnen und Durchkontaktierungen verbunden werden kann.

Bei einer weiteren Ausgestaltung der Erfindung weist das Halbleiterbauelement einen ersten Lastanschluss, der auf einer dem Schaltungsträger zugewandten Seite des Halbleiterbauelements angeordnet ist und mit einem Kontaktpad des Schaltungsträgers elektrisch verbunden ist, und einen zweiten Lastanschluss, der auf einer dem Leadframe zugewandten Seite des Halbleiterbauelements angeordnet ist und mit dem Leadframe elektrisch verbunden ist, auf. Mit anderen Worten weist das Halbleiterbauelement an sich gegenüberliegenden Seiten angeordnete Lastanschlüsse auf, die jeweils mit dem Schaltungsträger beziehungsweise mit dem Leadframe elektrisch kontaktiert werden. Dadurch wird eine Kontaktierung des Halbleiterbauelements ermöglicht, die analog zu der aus WO 2020/249479 A1 bekannten Kontaktierung ist.

Bei einer weiteren Ausgestaltung der Erfindung ist das Halbleiterbauelement ein Transistor oder eine Diode oder ein Thyristor. Eine erfindungsgemäße Schaltungsanordnung eignet sich für alle diese Halbleiterbauelemente, da alle diese Halbleiterbauelemente derart ausgeführt werden können, dass ihre Lastanschlüsse an einander gegenüberliegenden Seiten des Halbleiterbauelements angeordnet sein können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 eine schematische Schnittdarstellung eines ersten Ausführungsbeispiels einer Schaltungsanordnung,
FIG 2 eine schematische Schnittdarstellung eines zweiten Ausführungsbeispiels einer Schaltungsanordnung.

Einander entsprechende Teile sind in den Figuren mit denselben Bezugszeichen versehen.

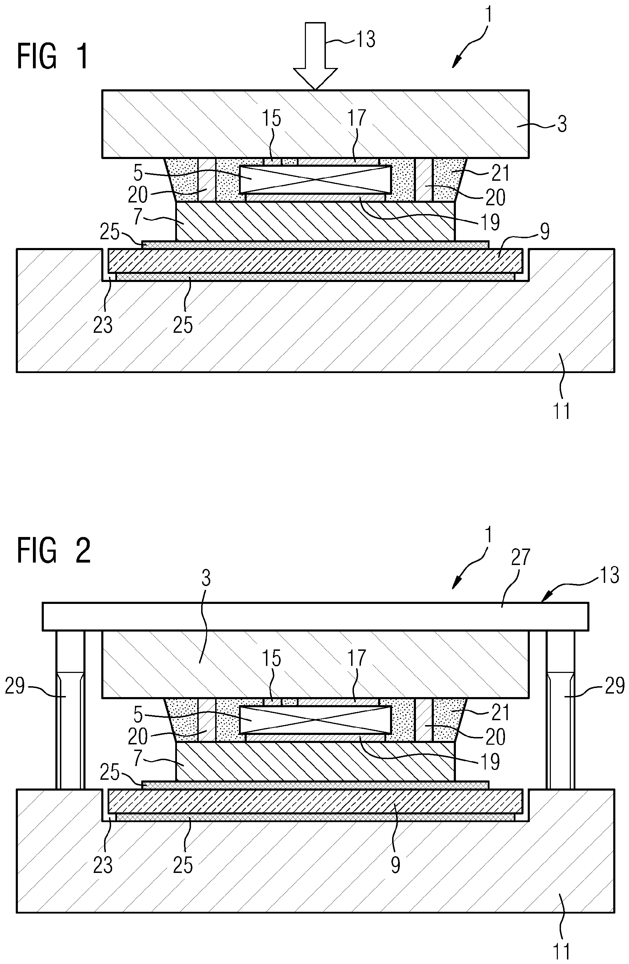

Figur 1 (FIG 1) zeigt eine schematische Schnittdarstellung eines ersten Ausführungsbeispiels einer Schaltungsanordnung 1.

Die Schaltungsanordnung 1 umfasst einen Schaltungsträger 3, ein Halbleiterbauelement 5, ein Leadframe 7, ein Isolationselement 9, einen Kühlkörper 11 und eine Andrückeinrichtung 13.

Das Halbleiterbauelement 5 ist zwischen dem Schaltungsträger 3 und dem Leadframe 7 angeordnet. In dem dargestellten Ausführungsbeispiel ist das Halbleiterbauelement 5 ein Transistor mit einem Steueranschluss, einem ersten Lastanschluss und einem zweiten Lastanschluss. Der Steueranschluss und der erste Lastanschluss sind dem Schaltungsträger 3 zugewandt, der zweite Lastanschluss ist dem Leadframe 7 zugewandt. Bei anderen Ausführungsbeispielen kann das Halbleiterbauelement 5 beispielsweise eine Diode oder ein Thyristor sein. Wenn das Halbleiterbauelement 5 eine Diode ist, weist es keinen Steueranschluss, sondern nur zwei Lastanschlüsse auf.

Der Steueranschluss des Halbleiterbauelements 5 ist mit einem ersten Kontaktpad 15 des Schaltungsträgers 3 verbunden. Der erste Lastanschluss des Halbleiterbauelements 5 ist mit einem zweiten Kontaktpad 17 des Schaltungsträgers 3 verbunden. Das erste Kontaktpad 15 und das zweite Kontaktpad 17 sind auf einer dem Halbleiterbauelement 5 zugewandten Seite des Schaltungsträgers 3 angeordnet. Der zweite Lastanschluss des Halbleiterbauelements 5 ist durch ein Verbindungsmaterial 19, beispielsweise ein Lot- oder Sintermaterial, mit dem Leadframe 7 verbunden.

Der Schaltungsträger 3 ist beispielsweise eine mehrlagige Leiterplatte, in der Durchkontaktierungen verlaufen, die jedes Kontaktpad 15, 17 mit wenigstens einer Leiterbahn der Leiterplatte verbinden.

Das Leadframe 7 ist aus einem Material gefertigt, das einen ähnlichen Wärmeausdehnungskoeffizienten wie der Schaltungsträger 3 aufweist. Im Fall, dass der Schaltungsträger 3 eine Leiterplatte ist, kann das Leadframe 7 beispielsweise aus Kupfer gefertigt sein. Das Leadframe 7 ist ferner über elektrisch leitende Verbindungen 20 mit dem Schaltungsträger 3 verbunden. Der übrige Zwischenraum zwischen dem Leadframe 7 und dem Schaltungsträger 3 ist durch ein Vergussmaterial 21, beispielsweise durch ein Gießharz, gefüllt.

Der Kühlkörper 11 und das Isolationselement 9 sind auf einer dem Halbleiterbauelement 5 abgewandten Seite des Leadframes 7 angeordnet. Der Kühlkörper 11 weist leadframeseitig eine Aussparung 23 auf, deren Ausdehnung die Ausdehnung des Leadframes 7 überragt. In die Aussparung 23 ist das Isolationselement 9 eingelegt, dessen Ausdehnung ebenfalls die Ausdehnung des Leadframes 7 überragt. Das Isolationselement 9 ist somit zwischen dem Leadframe 7 und dem Kühlkörper 11 in der Aussparung 23 des Kühlkörpers 11 angeordnet.

Zwischen dem Isolationselement 9 und dem Kühlkörper 11 sowie zwischen dem Isolationselement 9 und dem Leadframe 7 ist jeweils ein Wärmeleitmedium 25 angeordnet. Das Wärmeleitmedium 25 ist beispielsweise ein Wärmeleitöl. Das Isolationselement 9 ist also weder mit dem Kühlkörper 11 noch mit dem Leadframe 7 stoffschlüssig verbunden, sondern nur in die Aussparung 23 des Kühlkörpers 11 eingelegt.

Das Isolationselement 9 ist aus einem elektrisch isolierenden Material mit einer guten Wärmeleitfähigkeit gefertigt. Beispielsweise ist das Isolationselement 9 eine Keramikplatte. Die Keramikplatte ist beispielsweise aus Aluminiumoxid, Aluminiumnitrid oder Siliziumnitrid gefertigt. Alternativ ist das Isolationselement 9 eine Isolationsfolie, die beispielsweise aus einem silikonbasierten Material gefertigt ist.

Die Andrückeinrichtung 13 ist eingerichtet, den Verbund aus dem Schaltungsträger 3, dem Halbleiterbauelement 5 und dem Leadframe 7 an das Isolationselement 9 und den Kühlkörper 11 zu drücken. In Figur 1 ist die Andrückeinrichtung 13 nur schematisch durch ein Pfeilsymbol dargestellt, das die Richtung einer von der Andrückeinrichtung 13 ausgeübten Andrücckraft darstellt.

Figur 2 (FIG 2) zeigt eine schematische Schnittdarstellung eines zweiten Ausführungsbeispiels einer Schaltungsanordnung 1. Dieses Ausführungsbeispiel unterscheidet sich von dem in Figur 1 dargestellten Ausführungsbeispiel lediglich dadurch, dass es schematisch eine konkrete Ausführung der Andrückeinrichtung 13 zeigt. Die Andrückeinrichtung 13 weist bei diesem Ausführungsbeispiel eine Andrückplatte 27 und Schraubverbindungen 29 auf. Die Andrückplatte 27 ist auf einer von dem Kühlkörper 11 abgewandten Seite des Schaltungsträgers 3 angeordnet. Die Schraubverbindungen 29 verbinden die Andrückplatte 27 mit dem Kühlkörper 11 und üben dabei über die Andrückplatte 27 eine Andrückkraft aus, die den Verbund aus dem Schaltungsträger 3, dem Halbleiterbauelement 5 und dem Leadframe 7 an das Isolationselement 9 und den Kühlkörper 11 drückt.

Wenn der Schaltungsträger 3 stabil genug ist, kann das in Figur 2 gezeigte zweite Ausführungsbeispiel zu einem dritten Ausführungsbeispiel abgewandelt werden, bei dem die Andrückplatte 27 entfällt und die Schraubverbindungen 29 den Schaltungsträger 3 direkt mit dem Kühlkörper 11 verbinden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Schaltungsanordnung (1), umfassend
- einen Schaltungsträger (3),
- ein Leadframe (7),
- ein zwischen dem Schaltungsträger (3) und dem Leadframe (7) angeordnetes Halbleiterbauelement (5),
- einen auf einer von dem Halbleiterbauelement (5) abgewandten Seite des Leadframes (7) angeordneten Kühlkörper (11),
- ein zwischen dem Leadframe (7) und dem Kühlkörper (11) angeordnetes elektrisch isolierendes Isolationselement (9) und
- eine Andrückeinrichtung (13), die eingerichtet ist, den Schaltungsträger (3), das Halbleiterbauelement (5), das Leadframe (7), das Isolationselement (9) und den Kühlkörper (11) aneinander zu drücken.

2. Schaltungsanordnung (1) nach Anspruch 1, wobei das Isolationselement (9) eine Keramikplatte ist.

3. Schaltungsanordnung (1) nach Anspruch 2, wobei die Keramikplatte aus Aluminiumoxid, Aluminiumnitrid oder Siliziumnitrid gefertigt ist.

4. Schaltungsanordnung (1) nach Anspruch 1, wobei das Isolationselement (9) eine Isolationsfolie ist.

5. Schaltungsanordnung (1) nach Anspruch 4, wobei die Isolationsfolie aus einem silikonbasierten Material gefertigt ist.

6. Schaltungsanordnung (1) nach einem der vorhergehenden Ansprüche, wobei der Kühlkörper (11) eine Aussparung (23) aufweist, in die das Isolationselement (9) eingelegt ist.

7. Schaltungsanordnung (1) nach einem der vorhergehenden Ansprüche, wobei das Isolationselement (9) weder mit dem Kühlkörper (11) noch mit dem Leadframe (7) stoffschlüssig verbunden ist.

8. Schaltungsanordnung (1) nach einem der vorhergehenden Ansprüche, wobei zwischen dem Isolationselement (9) und dem Kühlkörper (11) und/oder zwischen dem Isolationselement (9) und dem Leadframe (7) ein Wärmeleitmedium (25) angeordnet ist.

9. Schaltungsanordnung (1) nach Anspruch 8, wobei das Wärmeleitmedium (25) ein Wärmeleitöl ist.

10. Schaltungsanordnung (1) nach einem der vorhergehenden Ansprüche, wobei das Leadframe (7) und der Schaltungsträger (3) ähnliche Wärmeausdehnungskoeffizienten aufweisen.

11. Schaltungsanordnung (1) nach einem der vorhergehenden Ansprüche, wobei das Leadframe (7) aus Kupfer gefertigt ist.

12. Schaltungsanordnung (1) nach einem der vorhergehenden Ansprüche, wobei die Andrückeinrichtung (13) wenigstens eine Schraubverbindung (29) aufweist, die den Kühlkörper (11) mit dem Schaltungsträger (3) oder mit einer Andrückplatte (27), die auf einer von dem Kühlkörper (11) abgewandten Seite des Schaltungsträgers (3) angeordnet ist, verbindet.

13. Schaltungsanordnung (1) nach einem der vorhergehenden Ansprüche, wobei der Schaltungsträger (3) eine Leiterplatte, insbesondere eine mehrlagige Leiterplatte, ist.

14. Schaltungsanordnung (1) nach einem der vorhergehenden Ansprüche, wobei das Halbleiterbauelement (5) einen ersten Lastanschluss, der auf einer dem Schaltungsträger (3) zugewandten Seite des Halbleiterbauelements (5) angeordnet ist und mit einem Kontaktpad (17) des Schaltungsträgers (3) elektrisch verbunden ist, und einen zweiten Lastanschluss, der auf einer dem Leadframe (7) zugewandten Seite des Halbleiterbauelements (5) angeordnet ist und mit dem Leadframe (7) elektrisch verbunden ist, aufweist.

15. Schaltungsanordnung (1) nach einem der vorhergehenden Ansprüche, wobei das Halbleiterbauelement (5) ein Transistor oder eine Diode oder ein Thyristor ist.
